# EUROPEAN PATENT SPECIFICATION

(11) **EP 4 065 746 B1**
(45) Date of publication and mention of the grant of the patent: **04.09.2024**
(21) Application number: 20908221.3
(22) Date of filing: 22.12.2020
(51) Int. Cl.: C23C 16/455, C23C 16/40, C23C 16/34, C23C 16/04, C23C 16/02

(54) **METHOD FOR DEPOSITING A FILM**
VERFAHREN ZUM ABSCHEIDEN EINES FILMS
PROCÉDÉ DE DÉPÔT D'UN FILM

(30) Priority: 27.12.2019 US 201962954053 P
(43) Date of publication of application: 05.10.2022
(73) Proprietor: Versum Materials US, LLC, Tempe, AZ 85284 (US)
(72) Inventor: CHANDRA, Haripin, Tempe, AZ 85284 (US); LEI, Xinjian, Tempe, AZ 85284 (US); SPENCE, Daniel, P., Tempe, AZ 85284 (US); XIAO, Manchao, Tempe, AZ 85284 (US); PEARLSTEIN, Ronald, Martin, Tempe, AZ 85284 (US); MACDONALD, Matthew, R., Tempe, AZ 85284 (US); RAO, Madhukar, B., Tempe, AZ 85284 (US)
(74) Representative: Sommer, Andrea
(86) International application number: PCT/US2020/066553
(87) International publication number: WO 2021/133774

(56) References cited:
- WO-A2-2007/026010
- US-A1- 2012 052 681
- US-A1- 2012 168 772
- US-A1- 2012 302 071
- US-A1- 2013 078 392
- US-A1- 2017 092 495
- US-B1- 9 812 320
- US-B2- 10 103 026
- US-B2- 9 945 028

## Description

### Cross-reference to Related Application

This application for a patent claims priority to U.S. Provisional Patent Application No. 62/954,053 filed on December 27, 2019.

### Technical Field

In general, this disclosure relates to a method for depositing a film, and more particularly, to an atomic layer deposition method for depositing a film into a surface feature of a substrate.

### Background

Atomic layer deposition is a chemical process utilized to deposit a thin film on a substrate. In many instances the substrate undergoing the atomic layer deposition process includes one or more of the following high aspect ratio surface features formed therein: pores, trenches, shallow trench isolation, vias, reentrant feature, or the like. These high aspect features commonly include an opening, a top area, and a bottom area, and the film formed therein should be low in porosity.

In conventional atomic layer deposition, the opening to the surface feature narrows as film growth occurs during gap-fill. Eventually, the narrowing of the opening prohibits travel of reactants to lower parts of the surface feature, including both the top area and the bottom area. This restriction impedes further film growth inside the surface feature, thereby leading to a film formed within the surface feature with greater than desired porosity.

US Patent Application Publication No. 2019/0203354 A1 discloses a method and system for conformality modulation of metal oxide films in atomic layer deposition using chemical inhibition. Inhibiting precursors for metal oxide deposition may include chelating agents such as diketones.

US Patent Nos. 10,199,212 and 10,043,656 teach methods and apparatuses for selectively depositing silicon-containing or metal-containing dielectric material on silicon or metal surfaces selective to silicon oxide or silicon nitride materials. Acetyl chloride is used as a_blocking agent. US Patent No. 9,812,320 B1 discloses a method of filling gaps on a substrate: introducing a first reactant to the substrate with a first dose, thereby forming no more than about one monolayer by the first reactant; introducing a second reactant to the substrate with a second dose. The first reactant is introduced with a subsaturating first dose reaching only a top area of the surface of the one or more gaps and the second reactant is introduced with a saturating second dose reaching a bottom area of the surface of the one or more gaps. A third reactant may be provided which reacts with at least one of the first and second reactant. US 2012/0052681 A1 discloses a method of selectively forming a material, comprising: forming a blocking material over portions of a substrate and leaving at least one surface of the substrate exposed to the blocking material; forming a first thickness of at least one material by atomic layer deposition on the at least one exposed surface of the substrate selective to the blocking material; and exposing the blocking material to at least one organic material to restore the blocking material. US 9,945,028 B2 discloses a method of filling a recess with a nitride film including adsorbing a raw material gas containing an element forming the nitride film to be formed on a target substrate on which the recess is formed on its surface, and nitriding the adsorbed raw material gas by nitriding species to fill the recess. At least a portion of a period for forming the nitride film is used as a bottom-up growth period, for which a polymer material adsorbable to the surface of the target substrate is supplied in a gaseous state and is adsorbed to an upper portion of the recess to inhibit adsorption of the film-forming raw material gas, and for which the nitride film is grown from a bottom portion of the recess.

Accordingly, the present disclosure is directed to overcoming one or more problems set forth above, and/or other problems associated with known atomic layer deposition methods.

### Summary of the Invention

The invention is as disclosed in the appended claims.

The organic passivation agent is selected from acetals, ketals, orthoesters, and orthocarbonates, i.e. the organic passivation agent is selected from the group consisting of the following formulae:
I. acetals or ketals having a formula of R¹R²C(OR³)₂
II. orthoesters having a formula of R¹C(OR³)₃ and
III. orthocarbonates having a formula of C(OR³)₄
wherein R¹ is selected from the group consisting of hydrogen, C₁ to C₁₀ linear or branched alkyl, C₃ to C₁₀ linear or branched cyclic alkyl, C₂ to C₁₀ alkenyl, C₂ to C₁₀ alkynyl, and C₃ to C₁₀ aromatic hydrocarbon R² and R³ are independently selected from the group consisting of C₁ to C₁₀ linear or branched alkyl, C₃ to C₁₀ linear or branched cyclic alkyl, C₂ to C₁₀ alkenyl, C₂ to C₁₀ alkynyl, and C₃ to C₁₀ aromatic hydrocarbon.

In an exemplary embodiment, the organic passivation agent is at least one compound selected from the group consisting of tetramethyl orthocarbonate, tetraethyl orthocarbonate, tetra-n-propyl orthocarbonate, trimethyl orthoacetate, triethyl orthoacetate, 1,1,1-triethoxypentane, 1,1,1-triethoxyheptane, triethyl orthobenzoate, 2,2-diethoxypropane, 1,1-diethoxy-1-phenylethane, 4,4-diethoxyheptane, 4,4-diethoxynonane, trimethyl orthoformate, trimethyl orthoformate, and tri-n-propyl orthoformate.

The precursor is selected from the group consisting of organoaminosilanes, organoaminodisilanes, organoaminotrisilylamines, organoaminosiloxanes, organoaminocyclosiloxanes, and organoaminotitanium, organoaminohafnium, organoaminozirconium, organoaminotantalum, organoaminotungsten, organoaminomolybdenum, organoaminoaluminum, alkylaluminum, and metal alkoxides. In addition, the oxygen source is selected from the group consisting of oxygen, oxygen plasma, water vapor plasma, a mixture of water and organic amine, hydrogen peroxide, nitrous oxide, ozone, carbon dioxide plasma, carbon monoxide plasma, and combinations thereof. And the nitrogen source may be selected from the group consisting of ammonia, hydrazine, methylhydrazine, 1,1-dimethylhydazine, N₂ plasma, ammonia plasma, hydrogen/nitrogen plasma, and combinations thereof.

The surface features of the present disclosure may have a depth to width aspect ratio of at least 2:1 or higher, or even at least 4:1. In some instances, the surface features have a width of 100 nm or less, may be vias, may be trenches, or a combination of vias and trenches.

In an embodiment, the thickness of the film produced each time after performing the steps from introducing the surface features to the organic passivation agent, to purging the reactor of unreacted oxygen source or nitrogen source and by-products with an inert gas, is thicker toward the bottom of the surface features than toward the top of the surface feature.

### Detailed Description of the Invention

Described herein are compositions and processes related to fill a surface feature such as a via or a_trench with a silicon or metal oxide containing film in an atomic layer deposition (ALD) process, or in an ALD-like process, such as, and without limitation, cyclical chemical vapor deposition. According to an exemplary embodiment, non-silicon containing passivation agent reacts with exposed hydroxyl groups on substrate surface features resulting in "occupied" reactive sites on the surface features. Occupation of the reactive sites in turn prevents reaction of organoaminosilane with the occupied reactive sites, hence, preventing film growth on certain area of the surface features. The dose of passivation agent is controlled in order to limit diffusion of the passivation agent into lower areas in the surface features. Therefore, the upper substrate surface and upper parts of the surface features will be passivated more than bottom part of the trench structure, which in turn imparts lower film growth near the upper substrate surface and upper parts of the surface features and higher film growth near bottom of the substrate features. This method of limiting film growth at near the upper substrate surface and upper parts of the surface features maintains an opening for precursor and oxygen source to access the lower spaces in the surface features and completely fill such spaces with the film of interest.

When no passivation agent is used during film growth, such as in a conventional ALD conformal film growth method, the opening in the surface feature narrows as film growth occurs during gap-fill. Eventually, this narrowing prohibits access to the lower parts of the surface features and in turn impedes further film growth inside the trench resulting in porosity within the surface features. Similar defect phenomena are also observed when passivation agent diffuses into bottom of the trench, resulting in conformal film growth during trench filling.

The organic passivation agent described in this invention is selected from the group consisting of the following formulae:
IV. acetals or ketals having a formula of R¹R²C(OR³)₂
V. orthoesters having a formula of R¹C(OR³)₃ and
VI. orthocarbonates having a formula of C(OR³)₄
wherein R¹ is selected from the group consisting of hydrogen, C₁ to C₁₀ linear or branched alkyl, C₃ to C₁₀ linear or branched cyclic alkyl, C₂ to C₁₀ alkenyl, C₂ to C₁₀ alkynyl, and C₃ to C₁₀ aromatic hydrocarbon. R² and R³ are independently selected from the group consisting of C₁ to C₁₀ linear or branched alkyl, C₃ to C₁₀ linear or branched cyclic alkyl, C₂ to C₁₀ alkenyl, C₂ to C₁₀ alkynyl, and C₃ to C₁₀ aromatic hydrocarbon.

In one or more embodiments described above, the oxygen source is selected from the group consisting of oxygen, oxygen plasma, water vapor plasma, a mixture of water and organic amine, hydrogen peroxide, nitrous oxide, ozone, carbon dioxide plasma, carbon monoxide plasma, and combinations thereof.

In one or more of the embodiments described above, the nitrogen source includes, but are not limited to, ammonia, hydrazine, methylhydrazine, 1,1-dimethylhydazine, N₂ plasma, ammonia plasma, hydrogen/nitrogen plasma, and combinations thereof.

Not to be bound by theory, it is believed that the organic passivation agents are introduced via diligently controlling chamber pressures or pulsing time or vapor flux of the organic passivation agent or size of R¹⁻³ groups in formulae I to III in step c to mainly react with those hydroxy groups on the top surface area of the features, allowing the depositing precursor having at least one organoamino group to react with those unreacted hydroxyl groups on the bottom of the features in step e to anchor silicon or metal containing fragments. As a result, bottom-up deposition of silicon or metal oxide containing film can be achieved because step g regenerates those hydroxyl groups on the on top surface area of the features via oxidizing the organic passivation layer away whiles silicon or metal oxide containing film is formed on the bottom of the features.

Some exemplary organic passivation agents that may be utilized in the process described herein are depicted in Table 1 below.

**Table 1. Exemplary Passivation Agents**

| | | |
|---|---|---|
| 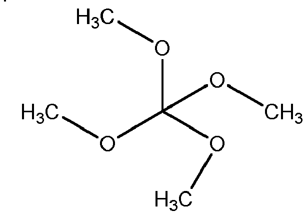 Tetramethyl orthocarbonate | 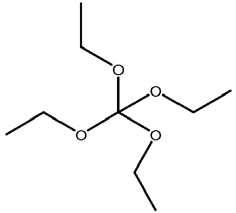 Tetraethyl orthocarbonate | 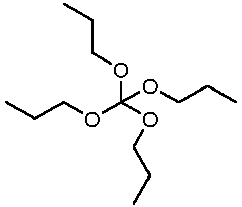 Tetra-n-propyl orthocarbonate |
| 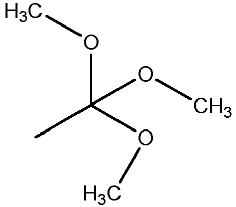 Trimethyl orthoacetate | 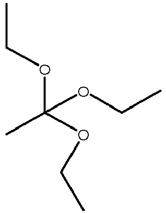 Triethylorthoacetate | 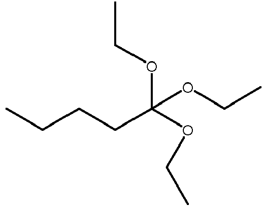 1,1,1-triethoxypentane |
| 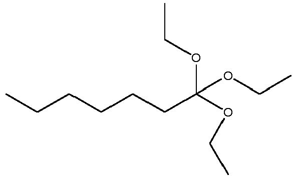 1,1,1-triethoxyheptane | 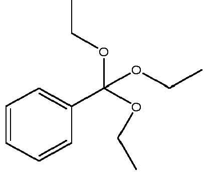 Triethyl orthobenzoate | 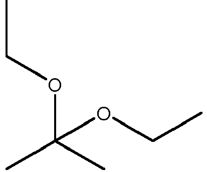 2,2-diethoxypropane |
| 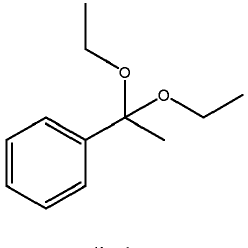 1,1-diethoxy-1-phenylethane | 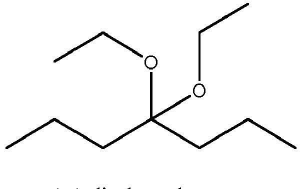 4,4-diethoxyheptane | 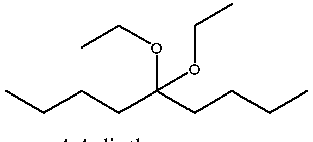 4,4-diethoxynonane |
| 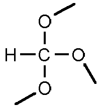 Trimethyl orthoformate | 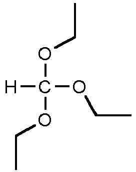 Trimethyl orthoformate | 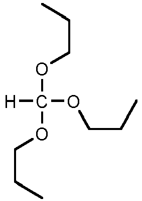 Tri-n-propyl orthoformate |

The depositing precursor for silicon oxide, silicon nitride, metal nitride or metal oxide having at least one organoamino or halogeno group can be selected from the group consisting of organoaminosilanes, organoaminodisilanes, organoaminotrisilylamines, organoaminosiloxanes, organoaminocyclosiloxanes, organoaminotitanium, organoaminohafnium, organoaminozirconium, organoaminotantalum, organoaminotungsten, organoaminomolybdenum, organoaminoaluminum, alkylaluminum, metal alkoxides, and any other silicon or metal containing precursors that may be utilized to deposit silicon oxide, carbon doped silicon oxide, and metal oxide.

Examples of organoaminosilanes include, but are not limited to di-iso-propylaminosilane, di-sec-butylaminosilane, bis(diethylamino)silane, bis(dimethylamino)silane, bis(ethylmethylamino)silane, bis(tert-butylamino)silane, diiso-propylaminomethylsilane, di-sec-butylaminomethylsilane, dimethylaminodimethylsilane, dimethylaminotrimethylsilane, bis(dimethylamino)methylsilane, tetrakis(dimethylamino)silane, tris(dimethylamino)silane, iso-propylaminotrimethylsilane, tertbutylaminotrimethylsilane, iso-butylaminotrimethylsilane, cyclohexaminotrimethylsilane, pyrrolidinotrimethylsilane, 2-methylpyrrolidinotrimethylsilane, 2,5-dimethylpyrrolidinotrimethylsilane, piperidinotrimethylsilane, 2,6-dimethylpiperidinotrimethylsilane, 1-methylpiperazinotrimethylsilane, pyrrolyltrimethylsilane, 2,5-dimethylpyrrolyltrimethylsilane, and imidazolyltrimethylsilane.

Examples of organoaminodisilanes include, but are not limited to, di-iso-propylaminodisilane, and di-sec-butylaminodisilane.

Examples of organoaminotrisilylamines include, but are not limited to, di-iso-propylaminotrisilylamine, diethylaminotrisilylamine, iso-propylaminotrisilylamine, and cyclohexylmethylaminotrisilylamine.

Examples of organoaminosiloxanes include, but are not limited to, 1-dimethylamino-pentamethyldisiloxane, 1-diethylamino-pentamethyldisiloxane, 1-ethylmethylamino-pentamethyldisiloxane, 1,3-bis(dimethylamino)tetramethyldisiloxane, 1-dimethylamino-heptamethyltrisiloxane, and 1,5-bis(dimethylamino)hexamethyltrisiloxane.

Examples of organoaminocyclosiloxanes include, but are not limited to, 2-dimethylamino-2,4,4,6,6-pentamethylcyclotrisiloxane, 2-diethylamino-2,4,4,6,6-pentamethylcyclotrisiloxane, 2-ethylmethylamino-2,4,4,6,6-pentamethylcyclotrisiloxane, 2-iso-propylamino-2,4,4,6,6-pentamethylcyclotrisiloxane, 2-dimethylamino-2,4,4,6,6,8,8-heptamethylcyclotetrasiloxane, 2-diethylamino-2,4,4,6,6,8,8-heptamethylcyclotetrasiloxane, 2-ethylmethylamino-2,4,4,6,6,8,8-heptamethylcyclotetrasiloxane, 2-iso-propylamino-2,4,4,6,6,8,8-heptamethylcyclotetrasiloxane, 2-dimethylamino-2,4,6-trimethylcyclotrisiloxane, 2-diethylamino-2,4,6-trimethylcyclotrisiloxane, 2-ethylmethylamino-2,4,6-trimethylcyclotrisiloxane, 2-iso-propylamino-2,4,6-trimethylcyclotrisiloxane, 2-dimethylamino-2,4,6,8-tetramethylcyclotetrasiloxane, 2-diethylamino-2,4,6,8-tetramethylcyclotetrasiloxane, 2-ethylmethylamino-2,4,6,8-tetramethylcyclotetrasiloxane, 2-iso-propylamino-2,4,6,8-tetramethylcyclotetrasiloxane, 2-pyrrolidino-2,4,6,8-tetramethylcyclotetrasiloxane, and 2-cyclohexylmethylamino-2,4,6,8-tetramethylcyclotetrasiloxane.

Examples of organoaminotitanium include, but are not limited to, tetrakis(dimethylamino)titanium, tetrakis(diethylamino)titanium, and tetrakis(ethylmethylamino)titanium.

Examples of organoaminohafnium include, but are not limited to, tetrakis(dimethylamino)hafnium (TDMAH), tetrakis(diethylamino)hafnium (TDEAH), tetrakis(ethylmethylamino)hafnium (TEMAH), cyclopentadienyltris(dimethylamino)hafnium (CpHf(NMe₂)₃), methylcyclopentadienyltris(dimethylamino)hafnium (MeCpHf(NMe₂)₃), ethylcyclopentadienyltris(dimethylamino)hafnium (EtCpHf(NMe₂)₃), cyclopentadienyltris(dimethylamino)hafnium (CpHf(NMeEt)₃), methylcyclopentadienyltris(dimethylamino)hafnium (MeCpHf(NMeEt)₃), ethylcyclopentadienyltris(dimethylamino)hafnium (EtCpHf(NMeEt)₃), cyclopentadienyltris(dimethylamino)hafnium (CpHf(NEt₂)₃), methylcyclopentadienyltris(dimethylamino)hafnium (MeCpHf(NEt₂)₃), ethylcyclopentadienyltris(dimethylamino)hafnium (EtCpHf(NEt₂)₃), bis(cyclopentadienyl)bis(dimethylamino)hafnium (Cp₂Hf(NMe₂)₂), bis(methylcyclopentadienyl)bis(dimethylamino)hafnium ((MeCp)₂Hf(NMe₂)₂), bis(ethylcyclopentadienyl)bis(dimethylamino)hafnium ((EtCp)₂Hf(NMe₂)₂), bis(cyclopentadienyl)bis(dimethylamino)hafnium (Cp₂Hf(NMeEt)₂), bis(methylcyclopentadienyl)bis(dimethylamino)hafnium ((MeCp)₂Hf(NMeEt)₂), bis(ethylcyclopentadienyl)bis(dimethylamino)hafnium ((EtCp)₂Hf(NMeEt)₂), bis(cyclopentadienyl)bis(dimethylamino)hafnium ((Cp₂Hf(NEt₂)₂), bis(methylcyclopentadienyl)bis(dimethylamino)hafnium ((MeCp)₂Hf(NEt₂)₃), bis(ethylcyclopentadienyl)bis(dimethylamino)hafnium ((EtCp)₂Hf(NEt₂)₂), (N-methyl-2, 4-cyclopentadiene-1-ethanamino]bis(dimethylamino)hafnium, (N-ethyl-2,4-cyclopentadiene-1-ethanamino]bis(dimethylamino)hafnium, (N-methyl-2,4-cyclopentadiene-1-ethanamino]bis(diethylamino)hafnium, (N-ethyl-2,4-cyclopentadiene-1-ethanamino]bis(diethylamino)hafnium, (*N*-methyl-2,4-cyclopentadiene-1-ethanamino] bis(ethylmethylamino)hafnium, (N-ethyl-2,4-cyclopentadiene-1-ethanamino], and bis(ethylmethylamino)hafnium.

Examples of organoaminozirconium include, but are not limited to, tetrakis(dimethylamino)zirconium (TDMAZ), tetrakis(diethylamino)zirconium(TDEAZ), tetrakis(ethylmethylamino)zirconium (TEMAZ), cyclopentadienyltris(dimethylamino)zirconium (CpZr(NMe₂)₃), methylcyclopentadienyltris(dimethylamino)zircnoum (MeCpZr(NMe₂)₃), ethylcyclopentadienyltris(dimethylamino)zirconium (EtCpZr(NMe₂)₃), cyclopentadienyltris(dimethylamino)zirconium (CpZr(NMeEt)₃), methylcyclopentadienyltris(dimethylamino)zirconium (MeCpZr(NMeEt)₃), ethylcyclopentadienyltris(dimethylamino)zirconium (EtCpZr(NMeEt)₃), cyclopentadienyltris(dimethylamino)zirconium (CpHf(NEt₂)₃), methylcyclopentadienyltris(dimethylamino)zirconium (MeCpZr(NEt₂)₃), ethylcyclopentadienyltris(dimethylamino)zirconium (EtCpZr(NEt₂)₃), bis(cyclopentadienyl)bis(dimethylamino)zirconium (Cp₂Zr(NMe₂)₂), bis(methylcyclopentadienyl)bis(dimethylamino)zirconium ((MeCp)₂Zr(NMe₂)₂), bis(ethylcyclopentadienyl)bis(dimethylamino)zirconium ((EtCp)₂Zr(NMe₂)₂), bis(cyclopentadienyl)bis(dimethylamino)zirconium (Cp₂Zr(NMeEt)₂), bis(methylcyclopentadienyl)bis(dimethylamino)zirconium ((MeCp)₂Zr(NMeEt)₂), bis(ethylcyclopentadienyl)bis(dimethylamino)zirconium ((EtCp)₂Zr(NMeEt)₂), bis(cyclopentadienyl)bis(dimethylamino)zirconium ((Cp₂Zr(NEt₂)₂), bis(methylcyclopentadienyl)bis(dimethylamino)zirconium ((MeCp)₂Zr(NEt₂)₃), bis(ethylcyclopentadienyl)bis(dimethylamino)zirconium ((EtCp)₂Zr(NEt₂)₂), (N-methyl-2,4-cyclopentadiene-1-ethanamino]bis(dimethylamino)zirconium, (N-ethyl-2,4-cyclopentadiene-1-ethanamino]bis(dimethylamino)zirconium, (N-methyl-2,4-cyclopentadiene-1-ethanamino]bis(diethylamino)zirconium, (N-ethyl-2,4-cyclopentadiene-1-ethanamino]bis(diethylamino)zirconium, (N-methyl-2,4-cyclopentadiene-1-ethanamino]bis(ethylmethylamino)zirconium, and (N-ethyl-2,4-cyclopentadiene-1-ethanamino]bis(ethylmethylamino)zirconium.

Examples of organoaminotantalum include, but are not limited to, (tertbutylimino)tris(dimethylamino)tantalum, (tert-butylimino)tris(diethylamino)tantalum, and (tert-butylimino)tris(ethylmethylamino)tantalum.

Examples of organoaminotantalum include, but are not limited to, bis(tertbutylimino)bis(dimethylamino)tungsten, bis(tert-butylimino)bis(diethylamino)tungsten, and bis(tert-butylimino)bis(ethylmethylamino)tungsten.

Examples of organoaminomolybdenum include, but are not limited to, bis(tertbutylimino)bis(dimethylamino)molybdenum, bis(tertbutylimino)bis(diethylamino)molybdenum, and bis(tertbutylimino)bis(ethylmethylamino)molybdenum.

Examples of organoaminoaluminum include, but are not limited to, tris(dimethylamino)aluminum, tris(diethylamino)aluminum, and tris(ethylmethylamino)aluminum.

Examples of alkylaluminum include, but are not limited to, trimethylaluminum, and triethylaluminum.

Examples of metal oxides include, but are not limited to, titanium iso-propoxide, titanium methoxide, titanium ethoxide, and aluminum iso-propoxide.

Examples of halegeno-silanes include: trichlorosilane, dichlorosilane, monochlorosilane, hexachlorodisilane, N-methyl-1,1,1,3,3,3-hexachlorodisilazane, silicon tetrachloride, 1-chloro-1,3-disilacyclobutane, 1-bromo-1,3-disilacyclobutane, 1,3-dichloro-1,3-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, and 1,3-diiodo-1,3-dimethyl-1,3-disilacyclobutane, 1,1,1,4,4,4-hexachloro-1,4-disilabutane, 1,1,1,4,4,4-hexachloro-2-methyl-1,4-disilabutane, 2,2,5,5,5-pentachloro-2,5-disilapentane, 2,2,5,5,5-pentachloro-3-methyl-2,5-disilapentane, 2,2,5,5-tetrachloro-2,5-disilahexane2,2,5,5-tetrachloro-3-methyl-2,5-disilahexane; 1,1,1,5,5,5-hexachloro-1,5-disilapentane, 2,2,6,6-tetrachloro-3-methyl-2,6-disilaheptane, 1,1,4,4-tetrachloro-1,4-disilapentane, 1,1,4,4-tetrachloro-2-methyl-1,4-disilapentane, 1,1,4,4,4-pentachloro-1,4-disilabutane, 1,1,4,4,4-pentachloro-2-methyl-1,4-disilabutane, 1,4,4,4-tetrachloro-1,4-disilabutane, 1,4,4,4-tetrachloro-2-methyl-1,4-disilabutane, 1,4,4-trichloro-1,4-disilapentane, 1,4,4-trichloro-2-methyl-1,4-disilapentane, 1,1,5,5,5-pentachloro-1,5-disilapentane, 1,1,5,5,5-pentachloro-2-methyl-1,5-disilapentane, 1,1,5,5-tetrachloro-1,5-disilahexane, 1,1,5,5-tetrachloro-2-methyl-1,5-disilahexane, 1,5,5,5-tetrachloro-1,5-disilapentane, 1,5,5,5-tetrachloro-2-methyl-1,5-disilapentane, 1,5,5-trichloro-1,5-disilahexane, and 1,5,5-trichloro-2-methyl-2,6-disilahexane, 1,1,1,3,3,3-hexachloro-1,3-disilapropane, 1,1,1,3,3,3-hexachloro-2-methyl-1,3-disilapropane, 1,1,1,3,3,3-hexachloro-2,2-dimethyl-1,3-disilapropane, and 1,1,1,3,3,3-hexachloro-2-ethyl-1,3-disilapropane.

The substrate comprises a surface feature. The term "surface feature(s)," or "features" as used herein, means that the substrate or partially fabricated substrate that comprises one or more of the following: pores, trenches, shallow trench isolation (STI), vias, reentrant feature, or the like. In one particular embodiment, the surface feature(s) have a width of 100 µm or less, 1 µm in width or less, or 0.5 µm in width or less, or 50 nm in width or less. In this or other embodiments, the aspect ratio (the depth to width ratio) of the surface features, if present, is 2:1 or greater, or 3:1 or greater, or 4:1 or greater, or 10:1 or greater, or 20:1 or greater, or 40:1 or greater. The high aspect ratio is referring to 2:1 or higher with width 100 nm or less, preferably 3:1 or higher with width 100 nm or less, most preferably 4:1 or higher with width 100 nm or less. The trench materials can be selected from Si, SiO₂, SiNₓ, carbon doped silicon oxide or combination of thereof.

In the formulae above and throughout the description, the term "linear alkyl" denotes a linear functional group having from 1 to 10, 3 to 10, or 1 to 6 carbon atoms. In the formulae above and throughout the description, the term "branched alkyl" denotes a linear functional group having from 3 to 10, or 1 to 6 carbon atoms. Exemplary linear alkyl groups include, but are not limited to, methyl, ethyl, propyl, butyl, pentyl, and hexyl groups. Exemplary branched alkyl groups include, but are not limited to, iso-propyl, isobutyl, sec-butyl, tert-butyl, iso-pentyl, tert-pentyl, iso-hexyl, and neo-hexyl. In certain embodiments, the alkyl group may have one or more functional groups such as, but not limited to, an alkoxy group, a dialkylamino group or combinations thereof, attached thereto. In other embodiments, the alkyl group does not have one or more functional groups attached thereto. The alkyl group may be saturated or, alternatively, unsaturated.

As mentioned previously, the method described herein may be used to deposit a silicon oxide or metal oxide into surface features comprising vias and/or trenches on at least a portion of a substrate. Examples of suitable substrates include, but are not limited to, silicon, SiO₂, titanium nitride, tungsten nitride, tantalum nitride, vanadium nitride, metals such as germanium, copper, titanium, tungsten, cobalt, ruthenium, platinum palladium, aluminum and combinations thereof.

The films are compatible with a variety of subsequent processing steps such as, for example, chemical mechanical planarization (CMP) and anisotropic etching processes.

The deposited films have applications, which include, but are not limited to, computer chips, optical devices, magnetic information storages, coatings on a supporting material or substrate, microelectromechanical systems (MEMS), nanoelectromechanical systems, thin film transistor (TFT), light emitting diodes (LED), organic light emitting diodes (OLED), IGZO, and liquid crystal displays (LCD).

### Examples

### Example 1: Impeding Silicon Oxide Film Growth on a Trench Structure

Film depositions were performed in a 300 mm plasma enhanced atomic layer deposition (PEALD) tool using FLR design. The reactor consisted of outer and inner chamber with dedicated pressure control. Ar flows to outer chamber maintaining pressure while all reactive chemicals were flown into inner reactor for deposition. The process, and its conditions, are depicted in Table 2.

**Table 2: Impeding Silicon Oxide Growth Process and Conditions**

| | | | |
|---|---|---|---|
| a | Insert Si substrates into a reactor | | |
| b | Heat substrates to desired temperature and pump out chamber to base pressure | 15 minutes | T = 300 °C |
| c | Introduce vapors of organic passivation agent into the reactor and soak | Vary | All gas flows are stopped. |
| | | | Throttle valve is closed to maintain chamber pressure. |
| | | | Flow organic passivation agent using vapor draw |
| d | Purge out unreacted organic passivation agent and byproducts | 5 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| e | Flow a depositing precursor having at least one organoamino group | 1 s | Outer chamber Ar flow = 500 sccm |
| | | | Outer chamber pressure = 3 Torr |
| | | | Inner (reaction) chamber: |
| | | | Ar flow = 300 sccm |
| | | | Precursor Ar carrier gas = 200 sccm |
| | | | Pressure = 2.5 Torr |
| f | Purge out unreacted precursor and by-products | 5 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| g | Introduce oxygen source | 2 s | Outer chamber Ar flow = 500 sccm |
| | | | Outer chamber pressure = 3 Torr |
| | | | Inner (reaction) chamber: |
| | | | Ar flow = 300 sccm |
| | | | Oxygen flow = 100 sccm |
| | | | Plasma frequency = 13.56 MHz |
| | | | Plasma power = 200 W |
| | | | Pressure = 2.5 Torr |
| h | Purge out unreacted precursor and byproducts | 5 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| i | Remove Si substrate from the reactor for characterizing the as-deposited film | | |

Steps c to h of the above outlined process may be repeated until a desired thickness is reached.

A Filmtek^{™} 3000 reflection and transmission spectrometer was used to measure thickness and refractive index of the deposited film, while a scanning electron microscope (SEM) and Transmission electron microscope (TEM) were used to inspect film quality.

A blanket film of silicon oxide was deposited using di-sec-butylaminosilane (DSBAS) as the depositing precursor, O₂ plasma as the oxygen source, and triethylorthoacetate (TEOA) as the organic passivation agent, utilizing the steps described in Table 2. The TEOA soaking time were varied between 0 s (no TEOA passivation agent) and 60 s. Susceptor temperature was set to 300 °C.

When no TEOA soak was used (0 s), the growth per cycle (GPC) was 1.18 Å/cycle while longer TEOA soak times impeded silicon oxide film growth down to 0.16 Å/cycle.

Silicon oxide film growth using a TEOA soak time of 0.5 s was performed on a trench structure with 10: 1 aspect ratio and a 150 nm opening. The TEOA exposure time was selected in sub-saturation mode, and therefor exposure of the passivating agent on top of the trench is higher than bottom of the trench. The sub-saturation mode can vary depending on the type of ALD reactors and should be obtained via similar experiments as in this example for a given ALD reactor.

TEM measurements of the deposited silicon oxide film thickness at different locations in the trench are shown in Table 3.

**Table 3: SiO₂ Film Thickness Deposited on a 10:1 Aspect Ratio Trench Structure**

| Top | Top corner | Bottom Corner | Bottom |
|---|---|---|---|
| 415 Å | 425 Å | 461 Å | 465 Å |

The film thickness at the top is thinner than at the bottom, which indicates that TEOA inhibits film deposition at the top portions of the trench structure, allowing bottom-up gap-fill when shorter TEOA exposure is used.

### Example2: Blocking SiNx Growth Deposited with N₂ Plasma on a Trench Structure

Film depositions were performed in a 300 mm PEALD tool using FLR design. The reactor consisted of outer and inner chamber with dedicated pressure control. Ar flows to outer chamber maintaining pressure while all reactive chemicals were flown into inner reactor for deposition. The process, and its conditions, are depicted below in Table 4.

**Table 4: Blocking SiNx Growth Process and Conditions**

| | | | |
|---|---|---|---|
| 1 | Insert Si substrates into a reactor | | |
| 2 | Heat substrates to desired temperature | 15 minutes | T = 300 °C |
| 3. | Pump out chamber to base pressure | 30s | |
| 4. | Soak using organic blocker precursor | Vary | All gas is stopped. |
| | | | Throttle valve is closed to maintain chamber pressure. |
| | | | Flow organic precursor using vapor draw |
| 5. | Purge precursor | 10 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| 6. | Flow the silicon precursor | 1 s | Outer chamber Ar flow = 500 sccm |
| | | | Outer chamber pressure = 3 Torr |
| | | | Inner (reaction) chamber: |
| | | | Ar flow = 300 sccm |
| | | | Precursor Ar carrier gas = 200 sccm |
| | | | Pressure = 2.5 Torr |
| 7. | Purge precursor | 10 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| 8. | Plasma for reactive gas | 10 s | Outer chamber Ar flow = 500 sccm |
| | | | Outer chamber pressure = 3 Torr |
| | | | Inner (reaction) chamber |
| | | | Ar flow = 300 sccm |
| | | | N2 flow = 100 sccm |
| | | | Pressure = 2.5 Torr |
| 9. | Purge precursor | 10 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| | | | Plasma: 27.1 MHz, 200 W |
| 10. | Remove Si substrate from the reactor | | |

In this process, steps 3 through 9 may be repeated to obtain a desired thickness.

In this example, di-sec-butylaminosilane (DSBAS) was used as silicon precursor. Triethylorthoacetate (TEOA) was used as organic blocker with flow of 0-10 seconds. Filmtek^{™} 3000 reflection and transmission instrument was used to measure thickness and refractive index of deposited film.

Table 5 below shows the effect of TEOA in reducing SiNx film GPC. It demonstrates that film growth is reduced to 0.06 Å/cycle after 10 s of TEOA exposure at each cycle. This is ~45% lower GPC than film growth without TEOA passivation and proves the dose sensitivity of the passivation process.

**Table 5. GPC for SiNx film growth after TEOA exposure**

| TEOA exposure (s) | GPC (Å/cycle) |
|---|---|
| 0 | 0.11 |
| 5 | 0.10 |
| 10 | 0.06 |

Silicon nitride (SiNₓ) film growth was explored using a TEOA soak time of 0.5 s on a trench structure with 10: 1 aspect ratio and a 150 nm opening. The TEOA exposure time was selected in sub-saturation mode. Therefore, exposure of passivating agent on top of the trench is higher than bottom of the trench.

TEM measurements of the deposited silicon nitride film thickness at different locations in the trench are shown in Table 6.

**Table 6: SiNₓ Film Thickness Deposited on a 10:1 Aspect Ratio Trench Structure**

| Top | Top corner | | Bottom Corner | Bottom |
|---|---|---|---|---|
| 275 Å | 280 Å | | 299Å | 306 Å |

The film thickness at the top is thinner than at the bottom, which indicates that TEOA inhibits film deposition at the top portions of the trench structure, allowing bottom-up fill film deposition possible when shorter TEOA exposure is used.

### Example 3 (non inventive) Silicon Oxide Film Growth on a Trench Structure Without Passivation Agent

Film depositions were performed in a 300 mm plasma enhanced atomic layer deposition (PEALD) tool using FLR design. The reactor consisted of outer and inner chamber with dedicated pressure control. Ar flows to outer chamber maintaining pressure while all reactive chemicals were flown into inner reactor for deposition. The process, and its conditions, are depicted in Table 7.

**Table 7: Silicon Oxide Film Growth Without Passivation Agent Process and Conditions**

| | | | |
|---|---|---|---|
| a | Insert Si substrates into a reactor | | |
| b | Heat substrates to desired temperature | 15 minutes | T = 300 °C |
| c | Flow the depositing precursor having at least one organoamino group | 1 s | Outer chamber Ar flow = 500 sccm |
| | | | Outer chamber pressure = 3 Torr |
| | | | Inner (reaction) chamber: |
| | | | Ar flow = 300 sccm |
| | | | Precursor Ar carrier gas = 200 sccm |
| | | | Pressure = 2.5 Torr |
| d | Purge out unreacted precursor and byproducts | 5 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| e | Introduce oxygen plasma | 2 s | Outer chamber Ar flow = 500 sccm |
| | | | Outer chamber pressure = 3 Torr |
| | | | Inner (reaction) chamber: |
| | | | Ar flow = 300 sccm |
| | | | Oxygen flow = 100 sccm |
| | | | Plasma frequency = 13.56 MHz |
| | | | Plasma power = 200 W |
| | | | Pressure = 2.5 Torr |
| f | Purge out unreacted precursor and byproducts | 5 s | Outer chamber Ar flow = 500 sccm |
| | | | Outer chamber pressure = 3 Torr |
| | | | Inner (reaction) chamber: |
| | | | Ar flow = 300 sccm |
| | | | Pressure = 2.5 Torr |
| g | Remove Si substrate from the reactor | | |

Steps c to f may be repeated multiple times to fill the gap.

In this example silicon oxide was deposited using di-sec-butylaminosilane (DSBAS) as the depositing precursor, and O₂ plasma as the oxygen source utilizing the process and conditions laid out above in Table 7.

TEM measurements of the deposited silicon oxide film at different locations is demonstrated below in Table 8.

**Table 8: SiO₂ Film Thickness Deposited on a 10:1 Aspect Ratio Trench Structure**

| Top | Top corner | Bottom Corner | Bottom |
|---|---|---|---|
| 405 Å | 410 Å | 402 Å | 409 Å |

As demonstrated above in Table 8, the film deposited without a passivation agent has a conformal film deposition.

### Example 4: Film Growth Inside a Trench Structure Using Long Passivation Agent Exposure

The process and conditions in this example are the same as outlined in Table 2 above except for the organic passivation agent soaking time. A blanket film of silicon oxide was deposited using di-sec-butylaminosilane (DSBAS) as the depositing precursor, O₂ plasma as the oxygen source, and triethylorthoacetate (TEOA) as the organic passivation agent. The TEOA soaking time were selected at 5 seconds.

TEM measurements of the deposited film thickness at different locations in the trench are shown in Table 9.

**Table 9: Silicon oxide film thickness deposited on 10:1 trench structure.**

| Top | Top corner | Bottom Corner | Bottom |
|---|---|---|---|
| 342 Å | 350 Å | 363 Å | 345 Å |

The film thickness from top is similar to the bottom, indicating conformal deposition. This suggested longer exposure time of passivation agent may not be suitable for bottom-up fill as it reacts with surface in the trench, both top and bottom evenly.

The above description is meant to be representative only, and thus modifications may be made to the embodiments described herein without departing from the scope of the disclosure. Thus, these modifications fall within the scope of the present disclosure and are intended to fall within the appended claims.

**Table 9: Silicon oxide film thickness deposited on 10:1 trench structure.**

| Top | Top corner | Bottom Corner | Bottom |
|---|---|---|---|
| 342 Å | 350 Å | 363 Å | 345 Å |

The film thickness from top is similar to the bottom, indicating conformal deposition. This suggested longer exposure time of passivation agent may not be suitable for bottom-up fill as it reacts with surface in the trench, both top and bottom evenly.

The above description is meant to be representative only, and thus modifications may be made to the embodiments described herein without departing from the scope of the disclosure. Thus, these modifications fall within the scope of the present disclosure and are intended to fall within the appended claims.

## Claims

1. An atomic layer deposition method for depositing a film into surface features of a substrate, the method comprising:
a) placing the substrate having surface features into a reactor, the surface features having exposed hydroxyl groups;
b) heating the reactor to one or more temperatures ranging from ambient temperature to about 700°C and optionally maintaining the reactor at a pressure of 100 torr or less;
c) introducing into the reactor at least one organic passivation agent, selected from the group consisting of acetals, ketals, orthoesters and orthocarbonates, to react with a portion of the exposed hydroxyl groups of the surface features;
d) purging unreacted organic passivation agent from the reactor using inert gas;
e) introducing a precursor gas having at least one organoamino group to react with any unreacted hydroxyl groups of the surface features;
f) purging unreacted precursor from the reactor using inert gas;
g) introducing an oxygen source or a nitrogen source into the reactor; and
h) purging unreacted oxygen source or nitrogen source and any byproducts with inert gas,
wherein steps c through h are repeated until the surface features are filled from the bottom-up,
wherein the organic passivation agent is selected from the group consisting of the following formulae:
I. acetals or ketals having a formula of R¹R²C(OR³)₂
II. orthoesters having a formula of R¹C(OR³)₃ and
III. orthocarbonates having a formula of C(OR³)₄
wherein R¹ is selected from the group consisting of hydrogen, C₁ to C₁₀ linear or branched alkyl, C₃ to C₁₀ linear or branched cyclic alkyl, C₂ to C₁₀ alkenyl, C₂ to C₁₀ alkynyl, and C₃ to C₁₀ aromatic hydrocarbon R² and R³ are independently selected from the group consisting of C₁ to C₁₀ linear or branched alkyl, , C₃ to C₁₀ linear or branched cyclic alkyl, C₂ to C₁₀ alkenyl, C₂ to C₁₀ alkynyl, and C₃ to C₁₀ aromatic hydrocarbon and
wherein the precursor is selected from the group consisting of organoaminosilanes, organoaminodisilanes, organoaminotrisilylamines, organoaminosiloxanes, organoaminocyclosiloxanes, and organoaminotitanium, organoaminohafnium, organoaminozirconium, organoaminotantalum, organoaminotungsten, organoaminomolybdenum, organoaminoaluminum, alkylaluminum, and metal alkoxides.

2. The method according to claim 1, wherein the organic passivation agent comprises at least one compound selected from the group consisting of tetramethyl orthocarbonate, tetraethyl orthocarbonate, tetra-n-propyl orthocarbonate, trimethyl orthoacetate, triethyl orthoacetate, 1,1,1-triethoxypentane, 1,1,1-triethoxyheptane, triethyl orthobenzoate, 2,2-diethoxypropane, 1,1-diethoxy-1-phenylethane, 4,4-diethoxyheptane, 4,4-diethoxynonane, trimethyl orthoformate, trimethyl orthoformate, and tri-n-propyl orthoformate.

3. The method according to claim 2, wherein the organic passivation agent comprises triethylorthoacetate.

4. The method according to claim 1, wherein the oxygen source is selected from the group consisting of oxygen, oxygen plasma, water vapor plasma, a mixture of water and organic amine, hydrogen peroxide, nitrous oxide, ozone, carbon dioxide plasma, carbon monoxide plasma, and combinations thereof.

5. The method according to claim 1, wherein the nitrogen source is selected from the group consisting of ammonia, hydrazine, methylhydrazine, 1,1-dimethylhydazine, N₂ plasma, ammonia plasma, hydrogen/nitrogen plasma, and combinations thereof.

6. The method according to claim 1, wherein the surface features have a depth to width aspect ratio of at least 2:1 or higher.

7. The method according to claim 6, wherein the aspect ratio is at least 4:1.

8. The method according to claim 6, wherein the surface features have a width of 100 nm or less.

9. The method according to claim 1, wherein the surface features are vias.

10. The method according to claim 1, wherein the surface features are trenches.

11. The method according to claim 1, wherein the surface features are vias and trenches.

12. The method according to claim 1, wherein the film produced each time after performing steps c) through h) is thicker toward the bottom of the surface features than toward the top of the surface feature.

## Patentansprüche

1. Ein Atomlagenabscheidungsverfahren zum Abscheiden eines Films in Oberflächenmerkmale eines Substrats, das Verfahren umfassend:
a) Einbringen des Substrats mit Oberflächenmerkmalen in einen Reaktor, wobei die Oberflächenmerkmale freiliegende Hydroxylgruppen aufweisen;
b) Erhitzen des Reaktors auf eine oder mehrere Temperaturen im Bereich von Umgebungstemperatur bis etwa 700°C und gegebenenfalls Aufrechterhalten des Reaktors bei einem Druck von 100 Torr oder weniger;
c) Einführen in den Reaktor mindestens eines organischen Passivierungsmittels, ausgewählt aus der Gruppe bestehend aus Acetalen, Ketalen, Orthoestern und Orthocarbonaten, um mit einem Teil der freiliegenden Hydroxylgruppen der Oberflächenmerkmale zu reagieren;
d) Spülen von nicht umgesetztem organischem Passivierungsmittel aus dem Reaktor unter Verwendung von Inertgas;
e) Einleiten eines Vorläufergases mit mindestens einer Organoaminogruppe, um mit allen nicht umgesetzten Hydroxylgruppen der Oberflächenmerkmale zu reagieren;
f) Spülen von nicht umgesetztem Vorläufer aus dem Reaktor unter Verwendung von Inertgas;
g) Einführen einer Sauerstoffquelle oder einer Stickstoffquelle in den Reaktor; und
h) Spülen der nicht umgesetzten Sauerstoffquelle oder Stickstoffquelle und aller Nebenprodukte mit Inertgas,
wobei die Schritte c bis h wiederholt werden, bis die Oberflächenmerkmale von unten nach oben gefüllt sind,
wobei das organische Passivierungsmittel aus der Gruppe ausgewählt ist, aus den folgenden Formeln bestehend:
I. Acetale oder Ketale mit der Formel R¹R²C(OR³)₂
II. Orthoester mit der Formel R¹C(OR³)₃ und
III. Orthocarbonate mit der Formel C(OR³)₄
worin R¹ ausgewählt ist aus der Gruppe bestehend aus Wasserstoff, linearem oder verzweigtem C₁- bis C₁₀-Alkyl, linearem oder verzweigtem cyclischem C₃- bis C₁₀-Alkyl, C₂- bis C₁₀-Alkenyl, C₂- bis C₁₀-Alkinyl und aromatischem C₃- bis C₁₀-Kohlenwasserstoff, R² und R³ unabhängig voneinander ausgewählt sind aus der Gruppe bestehend aus linearem oder verzweigtem C₁- bis C₁₀-Alkyl, linearem oder verzweigtem cyclischem C₃- bis C₁₀-Alkyl, C₂- bis C₁₀-Alkenyl, C₂- bis C₁₀-Alkinyl und aromatischem C₃- bis C₁₀-Kohlenwasserstoff und
wobei der Vorläufer ausgewählt ist, aus der Gruppe bestehend aus Organoaminosilanen, Organoaminodisilanen, Organoaminotrisilylaminen, Organoaminosiloxanen, Organoaminocyclosiloxanen und Organoaminotitan, Organoaminohafnium, Organoaminozirkonium, Organoaminotantal, Organoaminowolfram, Organoaminomolybdän, Organoaminoaluminium, Alkylaluminium und Metallalkoxiden.

2. Das Verfahren nach Anspruch 1, wobei das organische Passivierungsmittel mindestens eine Verbindung umfasst, die ausgewählt ist aus der Gruppe bestehend aus Tetramethylorthocarbonat, Tetraethylorthocarbonat, Tetra-n-propylorthocarbonat, Trimethylorthoacetat, Triethylorthoacetat, 1,1,1-Triethoxypentan, 1,1,1-Triethoxyheptan, Triethylorthobenzoat, 2,2-Diethoxypropan, 1,1-Diethoxy-1-phenylethan, 4,4-Diethoxyheptan, 4,4-Diethoxynonan, Trimethylorthoformiat, Trimethylorthoformiat und Tri-n-Propylorthoformiat.

3. Das Verfahren nach Anspruch 2, wobei das organische Passivierungsmittel Triethylorthoacetat umfasst.

4. Das Verfahren nach Anspruch 1, wobei die Sauerstoffquelle ausgewählt ist aus der Gruppe bestehend aus Sauerstoff, Sauerstoffplasma, Wasserdampfplasma, einer Mischung aus Wasser und organischem Amin, Wasserstoffperoxid, Distickstoffoxid, Ozon, Kohlenstoffdioxidplasma, Kohlenstoffmonoxidplasma und Kombinationen davon.

5. Das Verfahren nach Anspruch 1, wobei die Stickstoffquelle ausgewählt ist aus der Gruppe bestehend aus Ammoniak, Hydrazin, Methylhydrazin, 1,1-Dimethylhydrazin, N₂-Plasma, Ammoniakplasma, Wasserstoff/Stickstoff-Plasma und Kombinationen davon.

6. Das Verfahren nach Anspruch 1, wobei die Oberflächenmerkmale ein Seitenverhältnis von Tiefe zu Breite von mindestens 2:1 oder mehr aufweisen.

7. Das Verfahren nach Anspruch 6, wobei das Seitenverhältnis mindestens 4:1 beträgt.

8. Das Verfahren nach Anspruch 6, wobei die Oberflächenmerkmale eine Breite von 100 nm oder weniger aufweisen.

9. Das Verfahren nach Anspruch 1, wobei die Oberflächenmerkmale Durchkontaktierungen sind.

10. Das Verfahren nach Anspruch 1, wobei die Oberflächenmerkmale Furchen sind.

11. Das Verfahren nach Anspruch 1, wobei es sich bei den Oberflächenmerkmalen um Durchkontaktierungen und Furchen handelt.

12. Das Verfahren nach Anspruch 1, bei dem der jedes Mal nach Durchführung der Schritte c) bis h) hergestellte Film zur Unterseite der Oberflächenmerkmale hin dicker ist als zur Oberseite des Oberflächenmerkmals.

## Revendications

1. Procédé de dépôt d'une couche atomique pour le dépôt d'un film sur des caractéristiques de surface d'un substrat, le procédé comprenant :
(a) le placement du substrat ayant des caractéristiques de surface dans un réacteur, les caractéristiques de surface ayant des groupes hydroxyle exposés ;
(b) le chauffage du réacteur jusqu'à une ou plusieurs températures dans la plage de la température ambiante jusqu'à environ 700 °C et éventuellement le maintien du réacteur à une pression de 100 torr ou moins ;
(c) l'introduction dans le réacteur d'au moins un agent de passivation organique, choisi dans le groupe constitué par des acétals, des cétals, des orthoesters et des orthocarbonates, pour réagir avec une partie des groupes hydroxyle exposés des caractéristiques de surface ;
(d) la purge de l'agent de passivation organique n'ayant pas réagi du réacteur en utilisant un gaz inerte ;
(e) l'introduction d'un gaz précurseur ayant au moins un groupe organoamino pour réagir avec de quelconques groupes hydroxyle n'ayant pas réagi des caractéristiques de surface ;
(f) la purge du précurseur n'ayant pas réagi du réacteur en utilisant un gaz inerte ;
(g) l'introduction d'une source d'oxygène ou d'une source d'azote dans le réacteur ; et
(h) la purge de la source d'oxygène ou de la source d'azote n'ayant pas réagi et de quelconques sous-produits avec un gaz inerte,
les étapes c à h étant répétées jusqu'à ce que les caractéristiques de surface soient remplies du bas vers le haut,
l'agent de passivation organique étant choisi dans le groupe constitué par les formules suivantes :
I. acétals ou cétals ayant une formule de R¹R²C(OR³)₂
II. orthoesters ayant une formule de R¹C(OR³)₃ et
III. orthocarbonates ayant une formule de C(OR³)₄ R¹ étant choisi dans le groupe constitué par hydrogène, C₁ à C₁₀ alkyle linéaire ou ramifié, C₃ à C₁₀ alkyle cyclique linéaire ou ramifié, C₂ à C₁₀ alcényle, C₂ à C₁₀ alcynyle, et hydrocarbure aromatique en C₃ à C₁₀, R² et R³ étant indépendamment choisis dans le groupe constitué par C₁ à C₁₀ alkyle linéaire ou ramifié, C₃ à C₁₀ alkyle cyclique linéaire ou ramifié, C₂ à C₁₀ alcényle, C₂ à C₁₀ alcynyle, et hydrocarbure aromatique en C₃ à C₁₀ et le précurseur étant choisi dans le groupe constitué par des organoaminosilanes, des organoaminodisilanes, des organoaminotrisilylamines, des organoaminosiloxanes, des organoaminocyclosiloxanes et un organoaminotitane, un organoaminohafnium, un organoaminozirconium, un organoaminotantale, un organoaminotungstène, un organoaminomolybdène, un organoaminoaluminium, un alkylaluminium et des alcoxydes métalliques.

2. Procédé selon la revendication 1, l'agent de passivation organique comprenant au moins un composé choisi dans le groupe constitué par l'orthocarbonate de tétraméthyle, l'orthocarbonate de tétraéthyle, l'orthocarbonate de tétra-n-propyle, l'orthoacétate de triméthyle, l'orthoacétate de triéthyle, le 1,1,1-triéthoxypentane, le 1,1,1-triéthoxyheptane, l'orthobenzoate de triéthyle, le 2,2-diéthoxypropane, le 1,1-diéthoxy-1-phényléthane, le 4,4-diéthoxyheptane, le 4,4-diéthoxynonane, l'orthoformiate de triméthyle, l'orthoformiate de triméthyle et l'orthoformiate de tri-n-propyle.

3. Procédé selon la revendication 2, l'agent de passivation organique comprenant l'orthoacétate de triéthyle.

4. Procédé selon la revendication 1, la source d'oxygène étant choisie dans le groupe constitué par l'oxygène, un plasma d'oxygène, un plasma de vapeur d'eau, un mélange d'eau et d'une amine organique, le peroxyde d'hydrogène, l'oxyde nitreux, l'ozone, un plasma de dioxyde de carbone, un plasma de monoxyde de carbone et des combinaisons correspondantes.

5. Procédé selon la revendication 1, la source d'azote étant choisie dans le groupe constitué par l'ammoniac, une hydrazine, la méthylhydrazine, la 1,1-diméthylhydrazine, un plasma de N₂, un plasma d'ammoniac, un plasma d'hydrogène/azote et des combinaisons correspondantes.

6. Procédé selon la revendication 1, les caractéristiques de surface ayant un rapport d'aspect de profondeur sur largeur d'au moins 2 : 1 ou plus.

7. Procédé selon la revendication 6, le rapport d'aspect étant d'au moins 4 : 1.

8. Procédé selon la revendication 6, les caractéristiques de surface ayant une largeur de 100 nm ou moins.

9. Procédé selon la revendication 1, les caractéristiques de surface étant des trous d'interconnexion.

10. Procédé selon la revendication 1, les caractéristiques de surface étant des tranchées.

11. Procédé selon la revendication 1, les caractéristiques de surface étant des trous d'interconnexion et des tranchées.

12. Procédé selon la revendication 1, le film produit chaque fois après la réalisation des étapes c) à h) étant plus épais vers le fond des caractéristiques de surface que vers la partie supérieure de la caractéristique de surface.
